**Europäisches Patentamt**

**European Patent Office**

**Office européen des brevets**

(11) Veröffentlichungsnummer: **0 385 157**
**A1**

# (12) EUROPÄISCHE PATENTANMELDUNG

(21) Anmeldenummer: **90102620.3**

(22) Anmeldetag: **10.02.90**

(51) Int. Cl.5: **C23C 14/50**

(30) Priorität: **01.03.89 CH 753/89**

(43) Veröffentlichungstag der Anmeldung:
**05.09.90 Patentblatt 90/36**

(84) Benannte Vertragsstaaten:
**AT BE CH DE ES FR GB IT LI LU NL SE**

(71) Anmelder: **BALZERS AKTIENGESELLSCHAFT**

**FL-9496 Balzers(LI)**

(72) Erfinder: **Marent, Andreas**
**Alte Landstrasse 58**
**A-6700 Bludenz(AT)**
Erfinder: **Kündig, Max**
**Salätschis 624**
**CH-7214 Grüsch(CH)**
Erfinder: **Clinckemaillie, Alex**
**Am Sunnaberg 554**
**FL-9495 Triesen(LI)**

(74) Vertreter: **Troesch, Hans Alfred, Dr. Ing. et al**
**Walchestrasse 19**
**CH-8035 Zürich(CH)**

(54) **Substrathalter zur Aufnahme von zu beschichtenden Gläsern und kalottenförmiger Substratträger zur Aufnahme von Substrathaltern.**

(57) Der Substrathalter (8) dient der Aufnahme von zu beschichtenden Gläsern (17, 18). Er weist eine Lagerachse (10) auf, in deren Endbereichen je ein Querträger (14, 19) zur Aufnahme je eines Glases (17 bzw. 18) beidseits der Lagerachse (10) angeordnet ist. Die beiden Querträger (14, 19) verlaufen im wesentlichen rechtwinklig zur Lagerachse (10). Der eine ist mit je einem federnden Teil (20, 21), welcher Endschuhe (22, 23) aufweist, versehen. Der andere Querträger (14) ist steif. Er hat beidseits der Achse (10) eine Rille (15) zur Aufanhme je eines Glases (17 bzw. 18). Dabei sind die freien Trägerenden gegen den gegenüberliegenden Querträger (19) abgebogen. Dieser Substrathalter stellt sicher, dass die behandelten Gläser nicht nur paarweise genau gleich und optimal bedampft werden, sondern auch bezüglich weiterer Verfahrensschritte gleich sind, so dass daraus praktisch identische Gläserpaare am Ende ihrer Behandlung resultieren.

FIG. 2

## Substrathalter zur Aufnahme von zu beschichtenden Gläsern und kalottenförmiger Substratträger zur Aufnahme von Substrathaltern

Die vorliegende Erfindung betrifft einen Substrathalter zur Aufnahme von zu beschichtenden Gläsern sowie einen kalottenförmigen Substratträger zur Aufnahme von Substrathaltern in einer Vakuumanlage.

Für die Vakuumbeschichtung von Brillengläsern hat sich bekanntermassen eine Anordnung der Gläser auf einer Kugelkalottenfläche als optimal durchgesetzt.

Die bisherigen Wendesysteme für diese Gläser haben den Nachteil, dass aufgrund ihrer Flächengrösse die Kalottenform durch eine Ebene ersetzt wird. Dadurch kommt es zu einem Verlauf in der Schichtdicke, der eine unerwünschte Veränderung der Absorption oder Reflektion einer Beschichtung mit sich bringt.

In der Brillenglasrezeptfertigung ist die paarweise Verarbeitung (ein Kundenauftrag besteht immer aus zwei Gläsern) bis hin zur Reinigung vor dem Vakuumbeschichten eine Notwendigkeit. Für die Reinigung müssen aber üblicherweise die Gläser in Halterungskörbchen umsortiert und danach in die Substrathalterung gebracht werden, die normalerweise aus einem Ring besteht. Bei jedem dieser Vorgänge wird das Glas einzeln gehandhabt.

Das Einsetzen gereinigter Brillengläser in Substrathalter birgt die Gefahr von Fingerabdrücken auf der Glasoberfläche in sich, die sich nach dem Vakuumbeschichten als Fehler darstellen und das Glas zum Ausschuss machen.

Die US-PS 4 643 128 ermöglicht eine Zusammenfassung von zwei Paaren vor der Reinigung und bringt daher schon eine Verbesserung. Allerdings zeigt sich bei der Reinigung im Ultraschallbad, dass Flüssigkeitsreste von einem Gläserpaar auf das andere tropfen (was bei allen bisherigen Mehrfachglashalterungen aufgetreten ist), wodurch Antrocknungen entstehen, die bei der nachfolgenden Beschichtung zu Ausschuss führen.

Es sind m.a.W. zwar Substratträger bekannt, welche die Aufnahme je zweier Linsenpaare pro Oeffnung im kugelkalottenförmigen Substratträger vorsehen (US-PS 4 643 128). Ein solcher Substratträger ist aber mit einer speziellen Halterung zum gleichzeitigen Wenden der vier eingesetzten Gläser oder Linsen in der Bedampfungsanlage versehen. Diese Konstruktion erlaubt wohl eine gute Kapazitätsausnutzung und sichert kleine Stillstandzeiten der Bedampfungsanlage. Für die Behandlung der Gläser in der Vakuumanlage ist indessen die Schichtverteilung nicht optimal, da die so erzeugte Bedampfungsgeometrie an den Substraten vergleichsweise stark von der idealen Kugelgeometrie abweicht (Sehneneffekt). In der der Bedampfung vorangestellten Reinigung besteht die Gefahr, dass nach dem Spülen der Gläser die höherliegenden, die darunterliegenden durch die Abtropfflüssigkeit mit sog. Ablaufspuren verschmutzen, was ungleiche optische Qualitäten zur Folge haben kann. Dies wirkt sich insbe sondere bei Brillengläsern negativ aus, da beispielsweise ein obenliegendes Glas und ein darunterliegendes für die Herstellung einer Brille zur Anwendung gelangen können und diese beiden Gläser dann merklich ungleiche optische Eigenschaften aufweisen.

Die vorliegende Erfindung bezweckt die Schaffung eines kugelkalottenförmigen Substrathalters, welcher sicherstellt, dass die behandelten Gläser nicht nur paarweise genau gleich und optimal bedampft werden, sondern auch bezüglich weiterer Verfahrensschritte gleich sind, so dass praktisch identische Gläserpaare am Ende ihrer Behandlung sichergestellt sind.

Ein derartiger Substrathalter zeichnet sich durch den Wortlaut eines Anspruchs aus.

Dadurch wird u. a. sichergestellt, dass bei der Reinigung keine Abtropfflecken mehr auftreten können. Es kann mithin das erfindungsgemässe Halterungssystem gleichzeitig als Handlingsystem für die berührungslose Bearbeitung von Linsenpaaren in der Oberflächenveredelung von Brillengläsern verstanden werden.

Die Erfindung wird anschliessend beispielsweise anhand einer Zeichnung erläutert.

Es zeigen:

Fig. 1 eine Aufsicht auf einen Sektor eines kugelkalottenförmigen Substratträgers,

Fig. 1a, 1b Seitenansichten der Lagerstellen für die Substrathalter,

Fig. 2 eine Aufsicht auf einen Substrathalter mit der Lagerung im Kugelkalottenträger,

Fig. 3 eine Darstellung des Schwenkhebels des Substrathalters,

Fig. 4 eine Aufsicht auf die Lagerung der Achse eines Substrathalters.

Der Aufbau und die Funktion von Vakuumaufdampfanlagen, in welchen unter anderem auch Kunststoffbrillengläser, Linsen u.dgl. behandelt werden, sind im Fachgebiet bekannt. Es wird diesbezüglich auf die Veröffentlichung der Anmelderin "Substratträger und Drehantriebe zu Bedampfungsanlagen, BAK 600/760" verwiesen sowie auf die US-PS 4 643 128. Daher wird auf die eingehende Beschreibung derartiger Anlagen verzichtet.

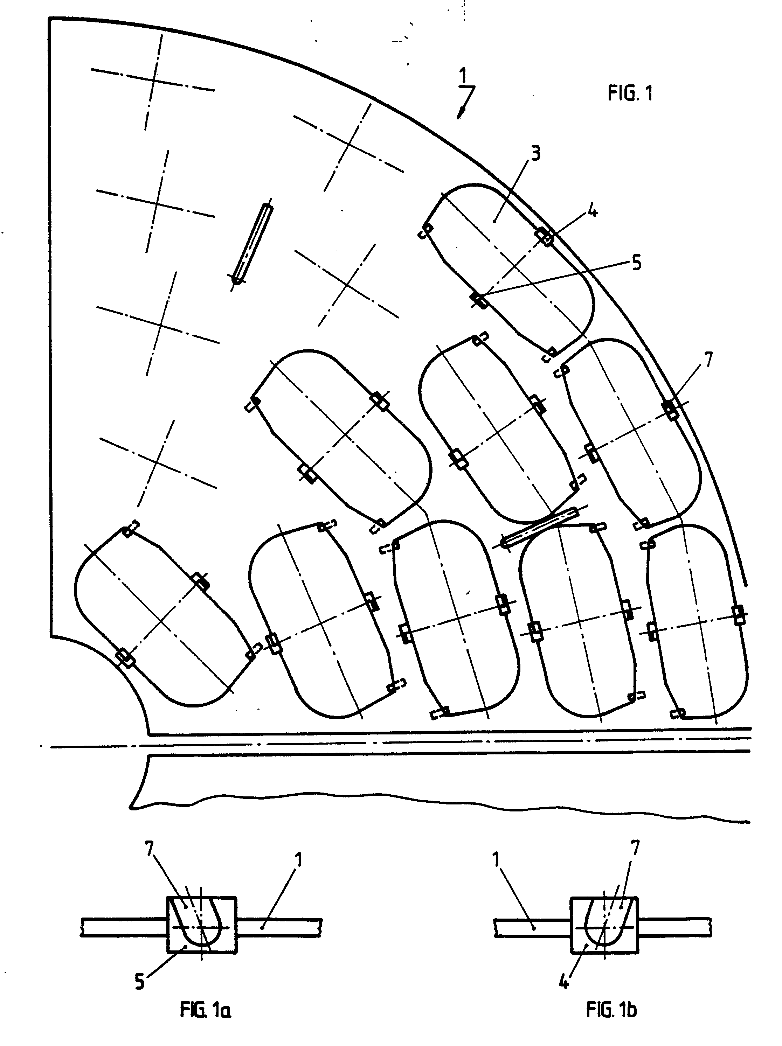

Im Sinne der vorliegenden Erfindung zeigt die Figur 1 eine Aufsicht auf einen Sektor 1 eines Substratträgers, welcher im vorliegenden Fall kugelkalottenförmig ausgebildet ist. Die folgenden Betrachtungen gelten aber ebenso für anders geformte Substratträger, wie Achteckkalotten u. dgl.

Im Sektor 1 sind Substrateinsatzöffnungen 3 ersichtlich, mit je zwei sich gegenüberliegenden Lagerschalen 4 und 5, deren nach oben offene Einlagenuten 7 zum drehbaren Festhalten eines Substrathalters 8 dienen.

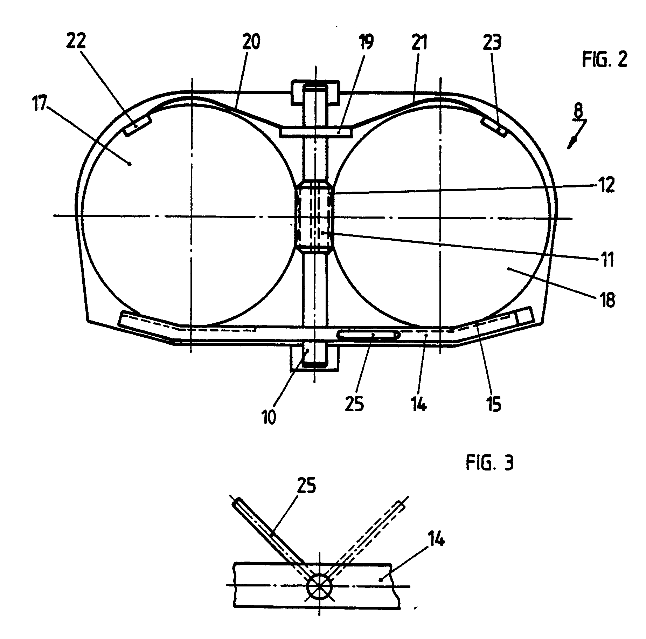

Der in Fig. 2 ersichtliche Substrathalter 8 weist eine Lagerachse 10 auf, deren Mitte als Haltezylinder 11 für die Halterung der zu behandelnden Brillengläser 17 und 18 dient. Zu diesem Zwecke ist der Haltezylinder 11 beidseits mit je einer Rille 12 versehen. Am einen Ende der Lagerachse 10 ist ein Querträger 14 mit Rillen 15 befestigt, welcher ebenfalls der Halterung der beiden Brillengläser 17 und 18 dient. Am anderen Ende der Lagerachse 10 befindet sich ein Federträger 19 mit zwei Blattfedern 20 und 21, deren Endschuhe 22 und 23 die beiden Brillengläser 17 und 18 in die Rillen 12 und 15 drücken.

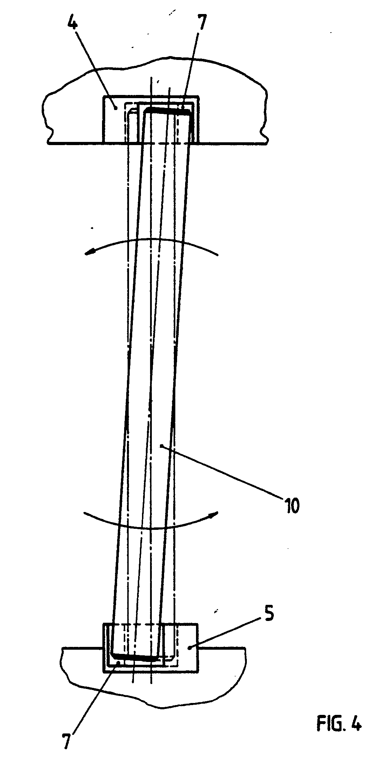

Der Querträger 14 ist mit einem Schwenkhebel 25 versehen, welcher dazu dient, den Substrathalter 8 und damit die zu behandelnden Brillengläser 17 und 18 in die jeweils optimale Lage zu schwenken. Dem Einnehmen der optimalen Behandlungslage der Brillengläser 17 und 18 dient auch die asymmetrische Anordnung der Substrathalter 8 in den jeweiligen Lagerschalen 4 und 5, wie dies die eingezeichnete Lagerachse 10 in Fig. 4 zeigt.

Damit wird sichergestellt, dass beim Wendevorgang die Substrathalter 8 nicht aus dem Substratträger 1 herausfallen; denn bei den bisherigen Konstruktionen führten die beim Wendevorgang in Erscheinung tretenden Kräfte zu Momenten, welche die Halter 8, vergleichsweise beide, aus der Kalotte heben konnten.

Bei der beschriebenen Ausführung (Fig. 4) drücken diese Momente infolge der asymmetrischen Anordnung die Halter 8 in die Nuten 7.

Auf diese Weise ist es möglich, jeweils ein Paar Brillengläser 17 und 18 praktisch identisch zu behandeln, wobei die Lage der Einsatzöffnungen 3 sowie der Lagerschalen 4 und 5 eine gegenseitige unerwünschte Beeinflussung der Brillengläser 17 und 18 verhütet und trotzdem eine optimale Ausnützung bezüglich Raum, Zeit und Behandlungsqualität sichergestellt wird.

Da die Behandlung der Gläser praktisch von einer Punktquelle aus erfolgt, wird deren Gleichmässigkeit dann sichergestellt, wenn die Gläser auf der Oberfläche einer Kugel liegen, deren Mittelpunkt durch das Zentrum, von dem die Behandlung ausgeht, gegeben ist. Damit wird es offensichtlich, dass, je grösser die Gläserzahl ist, die ein Halter aufnehmen kann, umso mehr die Lage des Behandlungsortes von der Kugelkalotte abweicht. Anstelle des Kreisbogens tritt dann die Sehne mit ihrem variierenden Abstand von der praktisch punktförmigen Behandlungsquelle. In diesem Sinne stellt die Behandlung paarweiser Linsen in beschriebener Art ein Optimum dar, indem praktisch identisch behandelte Brillengläser paarweise für einen Brillenträger verwendet werden können und andererseits mit Berücksichtigung dieses paarweisen Gebrauches bzw. der paarweisen Behandlung die Angleichung an eine Kugelkalottenfläche besser erfolgt, als bei der Behandlung von zwei und mehr Gläserpaaren in ein und demselben Halter.

Ein derartiger Substratträger optimiert die folgenden Bedingungen:
- Er gestattet ohne Gläserwechsel das Reinigen, Trocknen und Beschichten,
- freie Trägermaterialwahl (säure- und temperaturfest),
- keine Schmutzsammelnuten und -Bohrungen,
- beidseitige Beschichtung der Gläser ohne Wechsel,
- optimale geometrische Lage der Gläser für die Bedampfung,
- keine gegenseitige Beeinflussung beim Reinigen,
- kurze Stillstandzeiten der Vakuumanlage,
- optimale Platzausnützung,
- eindeutige Zuordnung eines Brillengläsersatzes während des ganzen Verfahrensablaufes.

Alle in der Beschreibung und/oder den Figuren dargestellten Einzelteile und Einzelmerkmale sowie deren Permutationen, Kombinationen und Variationen sind erfinderisch, und zwar für n Einzelteile und Einzelmerkmale mit den Werten n = 1 bis n→∞.

## Ansprüche

1. Substrathalter (8) zur Aufnahme von zu beschichtenden Gläsern (17, 18), gekennzeichnet durch eine Lagerachse (10), in deren Endbereichen je ein Querträger (14, 19) zur Aufnahme je eines Glases (17 bzw. 18) beidseits der Lagerachse (10) angeordnet ist.

2. Substrathalter, vorzugsweise nach mindestens einem der Ansprüche, dadurch gekennzeichnet, dass die beiden Querträger (14, 19) im wesentlichen rechtwinklig zur Lagerachse (10) verlaufen und der eine mit je einem federnden Teil (20, 21), vorzugsweise mit Endschuhen (22, 23), versehen ist.

3. Substrathalter, vorzugsweise nach mindestens einem der Ansprüche, dadurch gekennzeichnet, dass der eine Querträger (14) steif ist und er beidseits der Achse (10) eine Rille (15) zur Aufnahme je eines Glases (17 bzw. 18) aufweist, wobei vorzugsweise die freien Trägerenden gegen den gegenüberliegenden Querträger (19) abgebogen sind.

4. Substrathalter, vorzugsweise nach mindestens einem der Ansprüche, dadurch gekennzeichnet, dass der Mittelteil (11) der Lagerachse (10) Festhaltemittel, z.B. Rillen (12), für die beiden Gläser (17, 18) aufweist.

5. Substrathalter, vorzugsweise nach mindestens einem der Ansprüche, dadurch gekennzeichnet, dass die federnden Enden (22, 23) des einen Querträgers (19) derart auf die Gläser (17, 18) ansetzen, dass eine Kraftkomponente die Gläser in die Rillen (12) des Mittelteils (11) und die andere Komponente in die Rillen (15) des steifen Querträgers (14) pressen, wobei vorzugsweise die beiden Komponenten gleich gross sind.

6. Substrathalter, vorzugsweise nach mindestens einem der Ansprüche, dadurch gekennzeichnet, dass der, z.B. starre, Querträger (14) mit einem Schwenkhebel (25) versehen ist.

7. Kalottenförmiger Substratträger (1) zur Aufnahme von Substrathaltern (8) in einer Vakuumanlage, vorzugsweise nach mindestens einem der Ansprüche, gekennzeichnet durch Oeffnungen (3) zum Einlegen von je einem Substrathalter (8) pro Oeffnung, wobei der Substrathalter (8) zur Aufnahme nur zweier Gläser (17, 18) befähigt ist.

8. Substratträger, vorzugsweise nach mindestens einem der Ansprüche, dadurch gekennzeichnet, dass am Rand jeder Oeffnung (3) zwei sich gegenüberliegende Lagerschalen (4, 5) angeordnet sind, in deren nach aussen weisende Einlagenuten (7) die Achsen (10) der Substrathalter (8) einlegbar sind.

9. Substratträger, vorzugsweise nach mindestens einem der Ansprüche, dadurch gekennzeichnet, dass die bei den Nuten (7) zu ihrer Oeffnung (3) asymmetrisch angeordnet sind, um ein ungewolltes Herausfallen des Substrathalters (8) aus dem Substratträger (1) zu verhüten.

FIG. 1

FIG. 1a

FIG. 1b

FIG. 2

FIG. 3

EP 0 385 157 A1

FIG. 4

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A,D | GB-A-2 159 541 (BALZERS) <br> * Figuren; Seite 1, Zeilen 91-109; Ansrüche * <br> ----- | 1-9 | C 23 C 14/50 |

RECHERCHIERTE SACHGEBIETE (Int. Cl.5)

C 23 C
G 02 B

Der vorliegende Recherchenbericht wurde für alle Patentansprüche erstellt

| Recherchenort | Abschlußdatum der Recherche | Prüfer |
|---|---|---|
| DEN HAAG | 08-06-1990 | PATTERSON A.M. |